# EUROPÄISCHE PATENTANMELDUNG

(11) **EP 1 646 269 A2**
(43) Veröffentlichungstag der Anmeldung: **12.04.2006**
(21) Anmeldenummer: 05108651.0
(22) Anmeldetag: 20.09.2005
(51) Int. Cl.: H05K 1/11, H05K 1/16, H05K 9/00

(54) **Elektrische Schaltung mit einer Mehrlagen-Leiterplatte**

(30) Priorität: 11.10.2004 DE 102004049485
(71) Anmelder: SIEMENS AKTIENGESELLSCHAFT, 80333 München (DE)
(72) Erfinder: Berberich, Reinhold, 60439, Frankfurt (DE); Busch, Dieter, 61191, Rosbach (DE); Zintler, Albert, 64521, Groß-Gerau (DE)

(57) **Zusammenfassung**

Bei einer elektrischen Schaltung mit einer Mehrlagen-Leiterplatte und einem gegen elektro-magnetische Störungen abschirmenden Gehäuse (14,15) sind Teile mindestens einer äußeren Lage (1) als Kontaktfläche (6) ausgebildet, die mit jeweils einer Leiterfläche (10) auf einer weiteren Lage (2,3) kontaktiert sind, die einen gegenüber der Kontaktfläche (6) versetzten Flächenbereich einnimmt und mit einer gegenüber liegenden Massefläche (5) der äußeren Lage (1) einen Durchführungskondensator bildet.

## Beschreibung

Die Erfindung betrifft eine elektrische Schaltung mit einer Mehrlagen-Leiterplatte und einem gegen elektro-magnetische Störungen abschirmenden Gehäuse.

Durch zunehmende Verwendung von hochempfindlichen elektronischen Baugruppen treten Probleme bezüglich der elektromagnetischen Verträglichkeit auf. So befinden sich beispielsweise in einem Kraftfahrzeug Störungsquellen auf engstem Raum mit Schaltungen, welche niedrige Ausgangssignale von Sensoren verarbeiten und dabei noch äußerst zuverlässig arbeiten sollen. Außer einer Abschirmung derartiger Schaltungen mit Hilfe geeigneter Gehäuse werden dazu in den Zu- und Ableitungen dieser Baugruppen Durchführungskondensatoren angeordnet.

Aufgabe der vorliegenden Erfindung ist es, eine elektrische Schaltung anzugeben, die störunempfindlich ist und die mit möglichst geringem Aufwand hergestellt werden kann.

Diese Aufgabe wird bei der erfindungsgemäßen Schaltung dadurch gelöst, dass Teile mindestens einer äußeren Lage als Kontaktfläche ausgebildet sind, die mit jeweils einer Leiterfläche auf einer weiteren Lage kontaktiert sind, die einen gegenüber der Kontaktfläche versetzten Flächenbereich einnimmt und mit einer gegenüber liegenden Massefläche der äußeren Lage einen Durchführungskondensator bildet.

Die erfindungsgemäße Schaltung kann mit denjenigen Arbeitsgängen hergestellt werden, die zur Herstellung der Schaltung als solcher, nämlich der Herstellung der Mehrlagen-Leiterplatte und Durchkontaktierungen von einer Lage zur anderen, angewendet werden, ohne die Montage einzelner zusätzlicher Bauteile vornehmen zu müssen. Dadurch ergeben sich ein Kostenvorteil und eine Erhöhung der Zuverlässigkeit.

Eine vorteilhafte Ausgestaltung der Erfindung besteht darin, dass die mit jeweils mit einer Kontaktfläche kontaktierten Leiterflächen auf der zweitäußeren Lage angeordnet sind. Diese Ausgestaltung nutzt den Umstand, dass bei Mehrlagen-Schaltungen die äußeren Lagen meist einen wesentlich geringeren Abstand von beispielsweise 100 µm aufweisen als die mittleren Lagen, deren Abstand beispielsweise 1 mm beträgt. Dadurch ergeben sich ausreichend hohe Kapazitätswerte der Durchführungskondensatoren bei geringem Flächenbedarf.

Eine vorteilhafte Weiterbildung der Erfindung verbessert die Abschirmwirkung dadurch, dass Randbereiche der mindestens einen äußeren Lage, die nicht von Kontaktflächen eingenommen werden, Masseflächen zur Kontaktierung mit Gehäuseschalen bilden. Hierbei ist vorzugsweise vorgesehen, dass die Masseflächen beider äußeren Lagen in regelmäßigen Abständen durchkontaktiert sind.

Eine andere vorteilhafte Ausgestaltung der erfindungsgemäßen Schaltung besteht darin, dass die Kontaktflächen auf einer der äußeren Lagen angeordnet sind und mit jeweils einer Leiterfläche auf der benachbarten zweiten äußeren Lage und mit einer Leiterfläche auf der der anderen äußeren Lage benachbarten Lage kontaktiert sind und dass beide Leiterflächen mit jeweils einer Massefläche auf der jeweils benachbarten äußeren Lage Durchführungskondensatoren bilden.
Dadurch wird eine Verdoppelung der Kapazitätswerte erzielt.

Die Erfindung lässt zahlreiche Ausführungsformen zu. Eine davon ist schematisch in der Zeichnung anhand mehrerer Figuren dargestellt und nachfolgend beschrieben. Es zeigt:
- Figur 1: eine erste Lage,
- Figur 2: eine zweite und gegebenenfalls eine dritte Lage,
- Figur 3: eine vierte Lage einer Mehrlagen-Leiterplatte einer erfindungsgemäßen Schaltung,
- Figur 4: einen ersten Schnitt,
- Figur 5: einen zweiten Schnitt und
- Figur 6: einen dritten Schnitt durch eine erfindungsgemäße Schaltung.

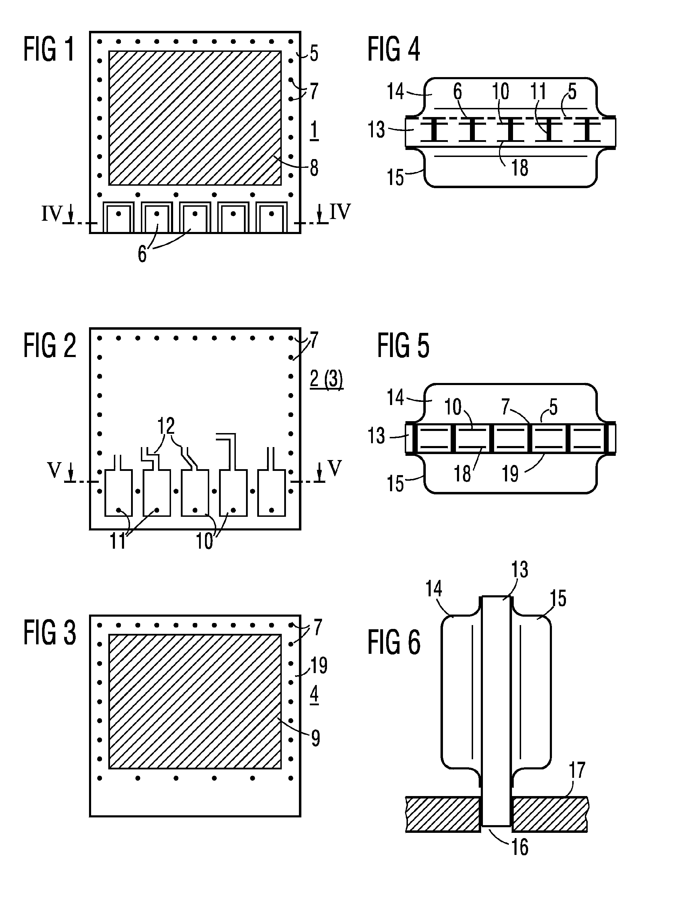

Die erste in Figur 1 gezeigte Lage 1 ist an Rändern mit Leiterbahnen 5 versehen, welche Masseflächen darstellen. Lediglich an dem in Figur 1 unten dargestellten Rand befinden sich fünf Kontaktflächen 6, die von den Leiterbahnen 5 isoliert sind. Die schwarzen Punkte stellen Durchkontaktierungen 7 zu Masseflächen 19 auf anderen Lagen dar, beispielsweise auf der vierten Lage 4 (Figur 3). Die in den Figuren 1 und 3 schraffiert dargestellten Flächen 8, 9 sind für in den Figuren nicht dargestellte Bauelemente vorgesehen. Die zweite Lage 2 sowie eine nicht dargestellte dritte Lage 3 befinden zwischen den Lagen 1 und 4 und weisen als Kondensatorplatten ausgebildete Leiterflächen 10 auf, die mit den Kontaktflächen 6 (Figur 1) mit Hilfe von Durchkontaktierungen 11 verbunden sind.

In Figur 2 sind Leiterbahnen 12, welche von den Leiterflächen 10 ausgehend die Struktur der Schaltung bilden, lediglich angedeutet.

Figur 4 zeigt den Schnitt IV (Figur 1), wobei außer der Mehrlagen-Leiterplatte 13 zwei Gehäuseschalen 14, 15 dargestellt sind. Figur 5 zeigt den Schnitt V (Figur 2). In den Figuren 4 und 5 ist auch die dritte Lage 3 mit Leiterflächen 18 erkennbar.

Figur 6 stellt eine erfindungsgemäße Schaltung dar, die in einen Schlitz 16 einer Hauptleiterplatte 17 eingesteckt ist, wobei die Kontaktflächen 6 mit entsprechenden Kontakten der Hauptleiterplatte 17 in bekannter Weise verbunden sind, was im Einzelnen nicht dargestellt ist.

## Patentansprüche

1. Elektrische Schaltung mit einer Mehrlagen-Leiterplatte und einem gegen elektro-magnetische Störungen abschirmenden Gehäuse, **dadurch** gekennzeich - net , dass Teile mindestens einer äußeren Lage (1) als Kontaktfläche (6) ausgebildet sind, die mit jeweils einer Leiterfläche (10) auf einer weiteren Lage (2, 3) kontaktiert sind, die einen gegenüber der Kontaktfläche (6) versetzten Flächenbereich einnimmt und mit einer gegenüber liegenden Massefläche (5) der äußeren Lage (1) einen Durchführungskondensator bildet.

2. Schaltung nach Anspruch 1, **dadurch** gekenn - zeichnet, dass die mit jeweils mit einer Kontaktfläche (6) kontaktierten Leiterflächen (10) auf der zweit äußeren Lage (2, 3) angeordnet sind.

3. Schaltung nach einem der Ansprüche 1 oder 2, da - durch **gekennzeichnet** , dass Randbereiche (5) der mindestens einen äußeren Lage (1), die nicht von Kontaktflächen eingenommen werden, Masseflächen zur Kontaktierung mit Gehäuseschalen (14, 15) bilden.

4. Schaltung nach Anspruch 3, **dadurch** gekenn - zeichnet , dass die Masseflächen (5) beider äußeren Lagen (1, 4) in regelmäßigen Abständen durchkontaktiert sind.

5. Schaltung nach einem der vorhergehenden Ansprüche, **dadurch gekennzeichnet , dass** die Kontaktflächen (6) auf einer der äußeren Lagen angeordnet sind und mit jeweils einer Leiterfläche (10) auf der benachbarten zweiten äußeren Lage (2) und mit einer Leiterfläche (18) auf der der anderen äußeren Lage (4) benachbarten Lage (3) kontaktiert sind und dass beide Leiterflächen (10, 18) mit jeweils einer Massefläche (5, 19) auf der jeweils benachbarten äußeren Lage (1, 4) Durchführungskondensatoren bilden.
